# EUROPEAN PATENT SPECIFICATION

(11) **EP 3 676 098 B1**
(45) Date of publication and mention of the grant of the patent: **06.01.2021**
(21) Application number: 18807237.5
(22) Date of filing: 14.11.2018
(51) Int. Cl.: B24B 37/04, B41J 2/14, B41J 2/16

(54) **PROCESS FOR FORMING INKJET NOZZLE CHAMBERS**
VERFAHREN ZUR HERSTELLUNG VON TINTENSTRAHLDÜSENKAMMERN
PROCÉDÉ DE FORMATION DE CHAMBRES DE BUSES À JET D'ENCRE

(30) Priority: 27.11.2017 US 201762591093 P
(43) Date of publication of application: 08.07.2020
(73) Proprietor: Memjet Technology Limited, Dublin 2 (IE)
(72) Inventor: NORTH, Angus, North Ryde, NSW 2113 (AU); WALKER, Matthew, North Ryde, NSW 2113 (AU)
(86) International application number: PCT/EP2018/081277
(87) International publication number: WO 2019/101605

(56) References cited:
- EP-A2- 0 609 860
- EP-A2- 0 738 603
- EP-A2- 1 184 179
- JP-A- H08 142 339
- US-A- 5 126 768
- US-A1- 2002 109 756
- US-A1- 2003 067 516
- US-A1- 2003 085 951
- US-A1- 2007 081 049
- US-A1- 2008 136 868

## Description

### Field of the Invention

This invention relates to a process for forming inkjet nozzle chambers. It has been developed primarily to reduce the cost and complexity of MEMS processes for forming high density inkjet nozzle devices.

### Background of the Invention

The Applicant has developed a range of Memjet® inkjet printers as described in, for example, WO2011/143700, WO2011/143699 and WO2009/089567. Memjet® printers employ a stationary pagewide printhead in combination with a feed mechanism which feeds print media past the printhead in a single pass. Memjet® printers therefore provide much higher printing speeds than conventional scanning inkjet printers.

In order to minimize the amount of silicon, and therefore the cost of pagewide printheads, each Memjet® printhead IC is fabricated via an integrated CMOS/MEMS process to provide a high nozzle packing density. A typical Memjet® printhead IC contains 6,400 nozzle devices, which translates to 70,400 nozzle devices in an A4 printhead containing 11 Memjet® printhead ICs.

As described in US 7,246,886 a typical printhead fabrication process for Memjet® printhead ICs requires etching holes in a frontside surface of a CMOS wafer via DRIE (deep reactive ion etching), filling the holes with a sacrificial material (e.g. photoresist) to provide a planar frontside surface, and then subsequently building MEMS nozzle devices on the frontside of the wafer. Construction of nozzle chambers may be via, for example an additive MEMS process, in which chamber material is deposited into openings defined in a sacrificial scaffold (see, for example, the additive MEMS fabrication process described in US 7,857,428. Alternatively, construction of nozzle chamber may be defined via a subtractive MEMS process, in which the chamber material is deposited as a blanket layer and then etched to define a perimeter chamber wall (see, for example, the subtractive MEMS fabrication process described in US 7,819,503. After completion of all frontside MEMS fabrication steps, the wafer is thinned from the backside and trenches are etched from the backside to meet with the filled frontside holes. Finally, all sacrificial material is removed from frontside holes and MEMS nozzle chambers by oxidative ashing to provide fluidic connection between the wafer backside and frontside. In the resulting printhead IC, the frontside holes define individual inlet channels for nozzle chambers.

A critical stage of the fabrication methods described above is plugging the frontside holes with sacrificial material and planarizing the frontside surface of the wafer. If the frontside surface is not fully planar, then any lack of planarity is carried through subsequent MEMS fabrication steps and, ultimately, may lead to defective devices or weakened MEMS structures with shorter installed lifetimes. Typically, hole-filling is performed as a stepwise process in order to achieve the required planarity. One process for plugging holes formed by DRIE is described in US 7,923,379. An alternative process for plugging holes formed by DRIE is described in US 2016/0236930. Another example is known from US 2007081049.

Nevertheless, plugging of frontside holes adds cost and complexity to a MEMS process flow - both in the filling and planarizing steps as well in the removal of the sacrificial material used to fill the holes.

US 2002109756 teaches lamination of a dry film layer on a steel layer. The dry film layer here is not used as a sacrificial scaffold which is a projection of the pressure chamber and which is removed in a later step. In US 2002109756, further dry film layers and steel layers are stacked together to form the pressure chamber.

It would be desirable to provide an alternative MEMS process for forming inkjet nozzle chambers over a frontside hole, which reduces the cost and complexity of prior art processes.

### Summary of Invention

In a first aspect, there is provided a MEMS process according to claim 1.

The process according to the first aspect advantageously obviates a front hole filling and planarizing step, thereby resulting in a shorter and less expensive MEMS process flow compared to prior art processes described above. Moreover, the process according to the first aspect is advantageous compared to known dry film lamination processes, such as those described in US 4,558,333 (assigned to Canon Kabushika Kaisha), in that the chamber material deposited onto the layer of dry film photoresist may be a ceramic material (e.g. silicon oxide) depositable via a CVD process. Therefore, a nozzle plate of a resulting printhead (or printhead chip) is highly robust with excellent hardness as well as resistance to chemical or mechanical degradation.

According to the first aspect, the chamber material is selected from the group consisting of: silicon oxide, silicon nitride and silicon oxynitride. For example, a silicon oxide chamber material may be formed via CVD deposition of tetraethyl orthosilicate (TEOS), as is known in the art.

In some embodiments, the frontside surface comprises a bonded heater device, which is formed prior to the lamination step.

Preferably the process comprises additional MEMS fabrication steps. For example, formation of the chamber may be followed by backside wafer thinning and/or backside etching of ink supply channels to meet with the hole.

The nozzle opening may be aligned or offset from the hole, depending on the specific design of the inkjet chamber. In one embodiment, the inkjet chamber comprises a firing chamber having the nozzle opening and an antechamber having the hole, the firing chamber being laterally connected to the antechamber. Typically, the chamber walls define a perimeter wall of the inkjet chamber.

Preferably, the layer of dry film photoresist has a thickness in the range of 5 to 30 microns or 5 to 15 microns.

According to the first aspect, the wall openings are defined using photoimaging of the dry film photoresist.

Preferably, the dry film photoresist is a negative resist comprising an epoxy resin. Examples of such dry film photoresists are well known in the art and are commercially available from, for example, DJ MicroLaminates, Inc and Engineered Materials Systems, Inc.

Preferably, the deposition step (iii) is performed using at least one deposition method selected from the group consisting of: TEOS CVD; high density plasma CVD (HDPCVD); and plasma-enhanced CVD (PECVD).

TEOS (tetraethyl orthosilicate) CVD is known in the art as suitable for filling trenches, especially at low-pressures [see, for example, Shareef et al., Subatmospheric chemical vapor deposition ozone/TEOS process for SiO2 trench filling, Journal of Vacuum Science & Technology B, Nanotechnology and Microelectronics: Materials, Processing, Measurement, and Phenomena 13, 1888 (1995)]. Likewise, HDPCVD is suitable for filling trenches, as described in US 5,872,058, using a mixture of silane, oxygen and argon.

In some embodiments, the deposition of the chamber material is a single step process in which the chamber walls and chamber roof are formed simultaneously. The chamber roof may be planarized after deposition using CMP.

In other embodiments the deposition step (iii) comprises the sub-steps of:
(a) depositing, using a first deposition method, a first chamber material to fill the wall openings and form the chamber walls;
(b) planarizing an upper surface of the first chamber material; and
(c) depositing, using a second deposition method, a second chamber material over the planarized upper surface of the first chamber material.

The first and second chamber materials may be the same or different from each other. Typically, the first and second chamber materials are both silicon oxide.

The first and second deposition methods may be the same or different from each other. For example, the first deposition method may use TEOS CVD or HDPCVD, while the second deposition method may use, for example, PECVD.

Preferably, planarizing is performed using chemical-mechanical-planarization (CMP).

### Brief Description of the Drawings

Embodiments of the present invention will now be described by way of example only with reference to the accompanying drawings, in which:
Figure 1 is a schematic side view of a silicon substrate having a hole etched in frontside surface;
Figure 2 shows the substrate shown in Figure 1 after lamination of a dry film layer;
Figure 3 shows the substrate shown in Figure 2 after photoetching of the dry film layer;
Figure 4 shows the substrate shown in Figure 3 after deposition of chamber material;
Figure 5 shows the substrate shown in Figure 4 after etching of the chamber material;
Figure 6 shows the substrate shown in Figure 5 after oxidative removal of the dry film layer;
Figure 7 is a perspective of inkjet nozzle devices suitable for formation via the MEMS process flow shown in Figures 1 to 6;
Figure 8 is a sectional side view of the inkjet nozzle device shown in Figure 7.

### Detailed Description of the Invention

### MEMS Process Flow for Forming Inkjet Chambers

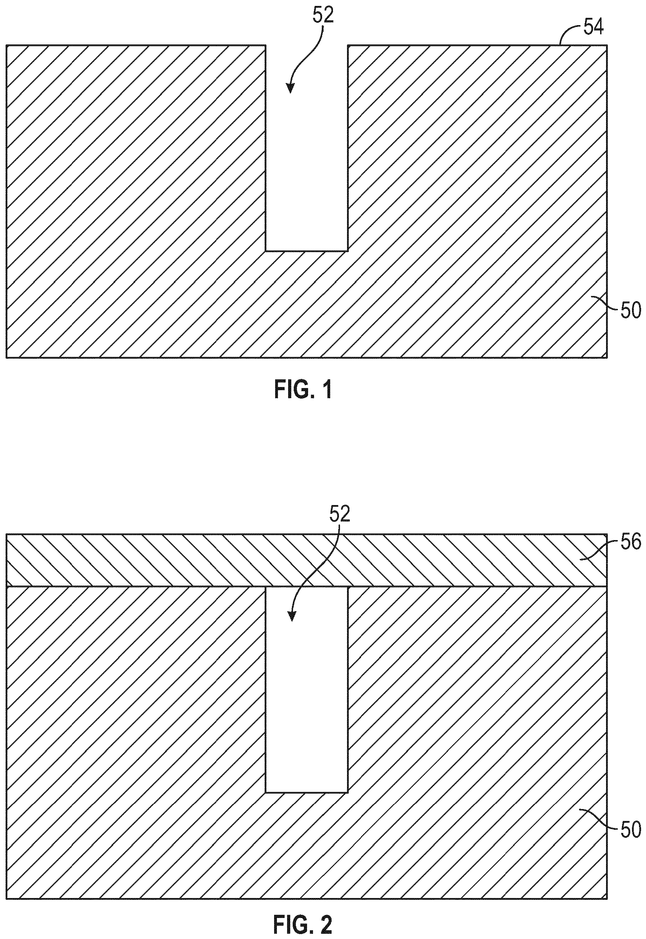

Figures 1 to 6 show schematically an exemplary MEMS process flow for forming inkjet chambers 70 according to the first aspect. Although the process is shown with reference to one unit cell of a wafer substrate, it will be appreciated that the process may be used to form a plurality (typically thousands) of identical unit cells on a single wafer substrate. The wafer is typically diced after completion of the MEMS processes to provide individual printhead chips, as known in the art.

In Figure 1, there is a shown a silicon substrate 50 having a frontside hole 52 formed in a frontside surface 54 of the substrate. The frontside hole 52 typically has a depth of at least 10 microns (e.g. 10 to 50 microns) and an aspect ratio of greater than 1:1. Referring to Figure 2, in a first step, a thin layer of photoimageable dry film photoresist 56 is laminated onto the frontside surface 54 of the substrate 50. The lamination process is optimized, as is known in the art, to minimize sagging of the dry film photoresist 56 into the frontside hole 52. The layer of dry film photoresist 56 may have a thickness in the range of 5 to 15 microns.

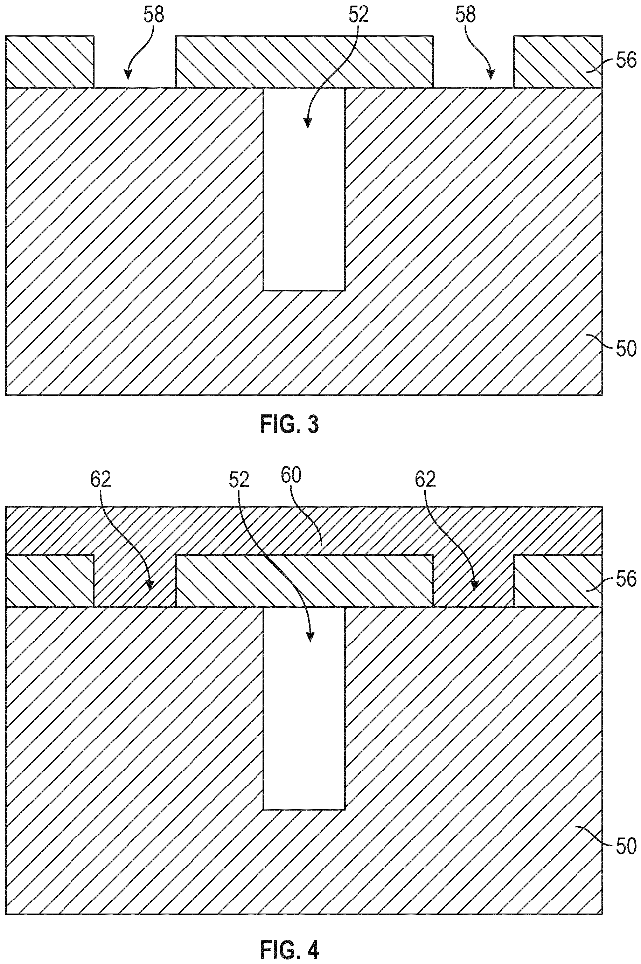

In a second step, and referring now to Figure 3, wall openings 58 are defined in the dry film photoresist 56 using a photoimaging ("photoetching") process. Typically, the dry film photoresist is a negative resist dry film whereby unexposed regions of the film are dissolved by a photoresist developer to define the wall openings 58.

In a third step, and referring now to Figure 4, a chamber material is deposited using a CVD process so as to fill the wall openings 58, thereby forming chamber walls 62 and a chamber roof 60. For example, a TEOS deposition may be used to fill the wall openings 58 with a silicon oxide chamber material. Alternatively, a high density plasma oxide deposition may be used to fill the wall openings 58 with a silicon oxide chamber material.

The dry film photoresist 56 may be thermally and/or UV cured prior to the relatively high temperature deposition step. Of course, other suitable depositable chamber materials (e.g. silicon nitride) may be used to form the chamber walls 62 and chamber roof 60.

The chamber walls 62 and chamber roof 60 may be co-formed in a single deposition step. Alternatively, the chamber walls 62 may be formed via an initial deposition filling the wall openings 58 following by a planarization step using chemical-mechanical-planarization (CMP). Following CMP, a subsequent deposition step may be used to thicken the chamber roof 60 to a desired thickness. A two-stage deposition process with CMP advantageously provides a more planar roof structure, which assists with providing more controlled nozzle etching in a subsequent step and, consequently, minimizes any undesirable nozzle size variation. A planar nozzle plate is also advantageous for printhead wiping.

It will be readily apparent that the chamber walls 62 and chamber roof 60 may be formed of the same or different materials using the two-stage deposition process in order to provide optimal characteristics for the inkjet chamber. Likewise, the first and second deposition steps may be performed using the same or different deposition methods in order to optimize inkjet chamber characteristics.

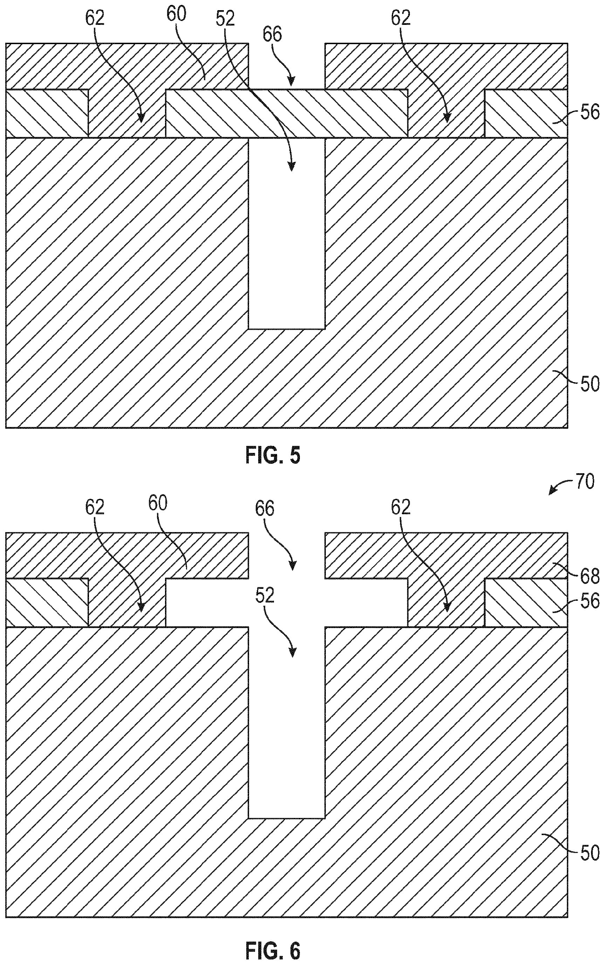

With the chamber roof 60 and chamber walls 62 formed, a nozzle opening 66 is defined in the chamber roof during a fourth step, as shown in Figure 5. The nozzle opening 66 is formed using conventional photolithographic masking and etching steps, as known in the art.

Finally, in a fifth step shown in Figure 6, the dry film photoresist 56 is removed via, for example, oxidative ashing to form the inkjet chamber 70 positioned over the frontside hole 52. Thus, in the novel MEMS process flow described herein, the dry film photoresist 56 is used as a sacrificial scaffold for forming the chamber roof 60 and chamber walls 62 via deposition of a ceramic material. In this way, highly robust inkjet chambers 70 may be formed over frontside holes 52 using ceramic materials without requiring filling and planarizing of the frontside holes. Moreover, any unashed dry film photoresist 56 trapped in cavities provide additional rigidity and support for a nozzle plate 68 spanning between chamber roofs 60.

In Figure 6, the nozzle opening 66 is aligned with the frontside hole 52, although it will of course be appreciated that the nozzle opening may be offset from the frontside hole, depending on the particular configuration of the inkjet nozzle device.

After frontside MEMS fabrication steps are completed, the wafer substrate 50 is typically thinned from a backside and an ink supply channel (not shown) is etched from the backside to meet with the frontside holes 52, thereby providing fluidic connection between the backside and frontside of the wafer substrate.

### MEMS Inkjet Nozzle Devices

By way of completeness, there will now be described an inkjet nozzle device 10, which may be fabricated using the MEMS process described above.

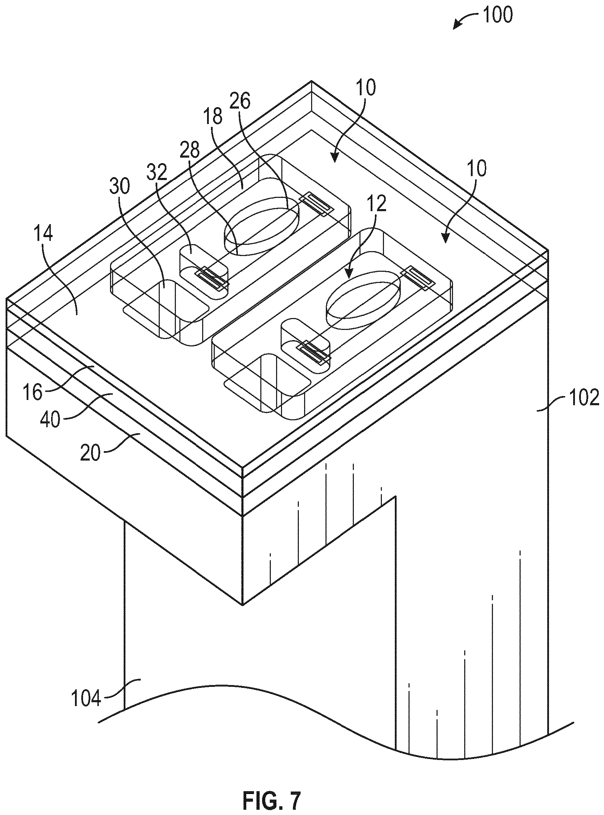

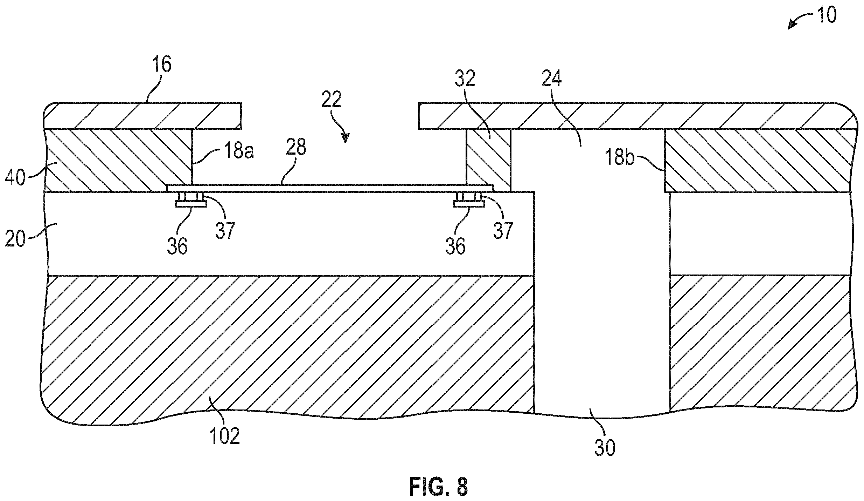

Referring to Figures 7 and 8, there is shown the inkjet nozzle device 10 comprising a main chamber 12 having a floor 14, a roof 16 and a perimeter wall 18 extending between the floor and the roof. Figure 7 shows a CMOS layer 20, which may comprise a plurality of metal layers interspersed with interlayer dielectric (ILD) layers.

In Figure 7 the roof 16 is shown as a transparent layer so as to reveal details of each nozzle device 10. Typically, the roof 16 and perimeter walls 18 are comprised of a ceramic material, such as silicon dioxide or silicon nitride.

The main chamber 12 of the nozzle device 10 comprises a firing chamber 22 and an antechamber 24. The firing chamber 22 comprises a nozzle aperture 26 defined in the roof 16 and an actuator in the form of a resistive heater element 28 bonded to the floor 14. The antechamber 24 comprises a main chamber inlet 30 (or "floor inlet 30") defined in the floor 14. The main chamber inlet 30 meets and partially overlaps with an endwall 18B of the antechamber 24. This arrangement optimizes the capillarity of the antechamber 24, thereby encouraging priming and optimizing chamber refill rates.

A baffle plate 32 partitions the main chamber 12 so as to define the firing chamber 22 and the antechamber 24. The baffle plate 32 extends between the floor 14 and the roof 16.

The antechamber 24 fluidically communicates with the firing chamber 22 via a pair of firing chamber entrances 34 which flank the baffle plate 32 on either side thereof. Each firing chamber entrance 34 is defined by a gap extending between a respective side edge of the baffle plate 32 and the perimeter wall 18.

The nozzle aperture 26 is elongate and takes the form of an ellipse having a major axis aligned with a central longitudinal axis of the heater element.

As best shown in Figure 8, the heater element 28 is connected at each end thereof to respective electrodes 36 exposed through the floor 14 of the main chamber 12 by one or more vias 37. Typically, the electrodes 36 are defined by an upper metal layer of the CMOS layer 20. The heater element 28 may be comprised of, for example, titanium-aluminium alloy, titanium aluminium nitride etc. In one embodiment, the heater 28 may be coated with one or more protective layers, as known in the art.

The vias 37 may be filled with any suitable conductive material (e.g. copper, tungsten *etc*.) to provide electrical connection between the heater element 28 and the electrodes 36. A suitable process for forming electrode connections from the heater element 28 to the electrodes 36 is described in US 8,453,329.

Part of each electrode 36 may be positioned directly beneath an end wall 18A and baffle plate 32 respectively. This arrangement advantageously improves the overall symmetry of the device 10, as well as minimizing the risk of the heater element 28 delaminating from the floor 14.

A printhead chip 100 may be comprised of a plurality of inkjet nozzle devices 10, although the partial cutaway view of the printhead chip 100 in Figure 7 shows only two inkjet nozzle devices 10 for clarity. The printhead chip 100 is defined by a printhead substrate 102 having the passivated CMOS layer 20 and a MEMS layer containing the inkjet nozzle devices 10. As shown in Figure 7, each main chamber inlet 30 meets with an ink supply channel 104 defined in a backside of the printhead chip 100. The ink supply channel 104 is generally much wider than the main chamber inlets 30 and provides a bulk supply of ink for hydrating each main chamber 12 in fluid communication therewith. Each ink supply channel 104 extends parallel with one or more rows of nozzle devices 10 disposed at a frontside of the printhead chip 100. Typically, each ink supply channel 104 supplies ink to a pair of nozzle rows (only one row shown in Figure 7 for clarity), in accordance with the arrangement shown in Figure 21B of US 7,441,865.

As foreshadowed above, the printhead chip 100 may be fabricated by building the MEMS layer containing inkjet nozzle devices 10 on a wafer substrate using a modified MEMS process flow based on the process described in connection with Figure 1 to 6. In the modified MEMS process flow, the baffle plate 32 is formed at the same time as the chamber walls 62 and chamber roof 60 by filling a suitable baffle opening (not shown) defined in the dry film photoresist 56. Accordingly, the process described herein provides an alternative to prior art processes for forming ceramic inkjet chambers over a frontside hole, which obviates filling and planarizing steps and thereby reduces the overall cost of printhead chip fabrication.

It will, of course, be appreciated that the present invention has been described by way of example only and that modifications of detail may be made within the scope of the invention, which is defined in the accompanying claims.

## Claims

1. A process for forming an inkjet chamber over a hole defined in a frontside surface of a wafer substrate, said process comprising the steps of:
(i) laminating a layer of dry film photoresist onto the frontside surface defining the hole, such that the layer of dry film photoresist bridges over the hole;
(ii) defining, using a photoimaging process, wall openings corresponding to chamber walls in the dry film photoresist;
(iii) depositing chamber material into the wall openings and over the dry film photoresist so as to form chamber walls and a chamber roof;
(iv) defining a nozzle opening in the chamber roof; and
(v) removing the dry film photoresist to form the inkjet chamber over the hole,
wherein the chamber material is selected from the group consisting of: silicon oxide, silicon nitride and silicon oxynitride.

2. The process of claim 1, wherein the frontside surface comprises a bonded heater device.

3. The process of claim 1 further comprising additional MEMS fabrication steps.

4. The process of claim 3, wherein a respective inlet for the inkjet chamber is defined by the hole.

5. The process of claim 4, further comprising at least one of: backside wafer thinning and backside etching of ink supply channels.

6. The process of claim 5, wherein the process forms a plurality of inkjet chambers and each ink supply channel meets with one or more of the holes.

7. The process of claim 6, wherein each ink supply channel is relatively wider than each hole.

8. The process of claim 1, wherein the nozzle opening is aligned or offset from the hole.

9. The process of claim 1, wherein the inkjet chamber comprises a firing chamber having the nozzle opening and an antechamber having the hole, the firing chamber being laterally connected to the antechamber.

10. The process of claim 9, wherein the chamber walls define a perimeter wall of the inkjet chamber.

11. The process of claim 1, wherein the layer of dry film photoresist has a thickness in the range of 5 to 20 microns.

12. The process of claim 1, wherein the dry film photoresist comprises an epoxy resin.

13. The process of claim 1, wherein the deposition step (iii) is performed using at least one deposition method selected from the group consisting of: TEOS CVD; high density plasma CVD (HDPCVD); and plasma-enhanced CVD (PECVD).

14. The process of claim 13, wherein the deposition step (iii) comprises the sub-steps of:
(a) depositing, using a first deposition method, a first chamber material to fill the wall openings, thereby forming the chamber walls and at least partially forming the chamber roof; and
(b) planarizing an upper surface of the first chamber material.

15. The process of claim 14 comprising the further sub-step of:
(c) depositing, using a second deposition method, a second chamber material over the planarized upper surface of the first chamber material so as to complete formation of the chamber roof.

## Patentansprüche

1. Verfahren zur Herstellung einer Tintenstrahlkammer über einem Loch, das in einer Vorderseitenfläche eines Wafer-Substrats definiert ist, das Verfahren die folgenden Schritte umfassend:
(i) Laminieren einer Schicht Trockenfilmfotoresist auf der Vorderseitenfläche, die das Loch derartig definiert, dass die Schicht Trockenfilmfotoresist das Loch überbrückt;
(ii) Definieren unter Verwendung eines lichtoptischen Abbildungsverfahrens von Wandöffnungen, die Kammerwänden in dem Trockenfilmfotoresist entsprechen;
(iii) Abscheiden von Kammermaterial in den Wandöffnungen und über dem Trockenfilmfotoresist, um so Kammerwände und ein Kammerdach auszubilden;
(iv) Definieren einer Düsenöffnung in dem Kammerdach; und
(v) Entfernen des Trockenfilmfotoresists, um die Tintenstrahlkammer über dem Loch auszubilden, wobei das Kammermaterial aus der Gruppe ausgewählt ist, bestehend aus: Siliziumoxid, Siliziumnitrid und Siliziumoxinitrid.

2. Verfahren nach Anspruch 1, wobei die Vorderseitenfläche eine gebondete Heizvorrichtung umfasst.

3. Verfahren nach Anspruch 1, weiterhin zusätzliche MEMS-Herstellungsschritte umfassend.

4. Verfahren nach Anspruch 3, wobei durch das Loch ein jeweiliger Einlass für die Tintenstrahlkammer definiert ist.

5. Verfahren nach Anspruch 4, weiterhin mindestens eines des Folgenden umfassend: Dünnätzen einer Wafer-Rückseite und Rückseitenätzen von Tintenzufuhrkanälen.

6. Verfahren nach Anspruch 5, wobei das Verfahren mehrere Tintenstrahlkammern ausbildet und jeder Tintenzufuhrkanal auf eines oder mehrere der Löcher trifft.

7. Verfahren nach Anspruch 6, wobei jeder Tintenzufuhrkanal relativ breiter ist als jedes Loch.

8. Verfahren nach Anspruch 1, wobei die Düsenöffnung zu dem Loch ausgerichtet ist oder dazu versetzt ist.

9. Verfahren nach Anspruch 1, wobei die Tintenstrahlkammer eine Expansionskammer mit der Düsenöffnung und eine Vorkammer mit dem Loch umfasst, wobei die Expansionskammer lateral mit der Vorkammer verbunden ist.

10. Verfahren nach Anspruch 9, wobei die Kammerwände eine Außenwand der Tintenstrahlkammer definieren.

11. Verfahren nach Anspruch 1, wobei die Schicht Trockenfilmfotoresist eine Dicke in dem Bereich von 5 bis 20 Mikron aufweist.

12. Verfahren nach Anspruch 1, wobei der Trockenfilmfotoresist ein Epoxidharz umfasst.

13. Verfahren nach Anspruch 1, wobei der Abscheidungsschritt (iii) unter Verwendung mindestens eines Abscheidungsverfahrens durchgeführt wird, das aus der Gruppe ausgewählt ist, bestehend aus: TEOS CVD; CVD mit hochdichtem Plasma (HDPCVD); und plasmagestützte CVD (PECVD).

14. Verfahren nach Anspruch 13, wobei der Abscheidungsschritt (iii) die folgenden Subschritte umfasst:
(a) Abscheiden unter Verwendung eines ersten Abscheidungsverfahrens eines ersten Kammermaterials, um die Wandöffnungen zu füllen, wodurch die Kammerwände ausgebildet werden und das Kammerdach mindestens teilweise ausgebildet wird; und
(b) Planarisieren einer oberen Oberfläche des ersten Kammermaterials.

15. Verfahren nach Anspruch 14, den folgenden weiteren Subschritt umfassend:
(c) Abscheiden unter Verwendung eines zweiten Abscheidungsverfahrens eines zweiten Kammermaterials über der planarisierten oberen Oberfläche des ersten Kammermaterials, um so eine Ausbildung des Kammerdachs zu vervollständigen.

## Revendications

1. Procédé pour former une chambre à jet d'encre par-dessus un trou défini dans une surface de côté avant d'un substrat de tranche, ledit procédé comprenant les étapes de :
(i) la stratification d'une couche de résine photosensible en film sec sur la surface de côté avant définissant le trou, de telle sorte que la couche de résine photosensible en film sec couvre le trou ;
(ii) la définition, en utilisant un procédé de photo-imagerie, d'ouvertures de paroi correspondant à des parois de chambre dans la résine photosensible en film sec ;
(iii) le dépôt de matériau de chambre dans les ouvertures de paroi et par-dessus la résine photosensible en film sec afin de former des parois de chambre et un toit de chambre ;
(iv) la définition d'une ouverture de buse dans le toit de chambre ; et
(v) l'enlèvement de la résine photosensible en film sec pour former la chambre à jet d'encre par-dessus le trou, dans lequel le matériau de chambre est sélectionné parmi le groupe constitué de : oxyde de silicium, nitrure de silicium et oxynitrure de silicium.

2. Procédé selon la revendication 1, dans lequel la surface de côté avant comprend un dispositif chauffant lié.

3. Procédé selon la revendication 1, comprenant en outre des étapes de fabrication de MEMS supplémentaires.

4. Procédé selon la revendication 3, dans lequel une entrée respective pour la chambre à jet d'encre est définie par le trou.

5. Procédé selon la revendication 4, comprenant en outre au moins un de : amincissement de tranche de côté l'arrière et gravure de côté arrière de canaux d'alimentation en encre.

6. Procédé selon la revendication 5, dans lequel le procédé forme une pluralité de chambres à jet d'encre et chaque canal d'alimentation en encre rencontre un ou plusieurs des trous.

7. Procédé selon la revendication 6, dans lequel chaque canal d'alimentation en encre est relativement plus large que chaque trou.

8. Procédé selon la revendication 1, dans lequel l'ouverture de buse est alignée ou décalée par rapport au trou.

9. Procédé selon la revendication 1, dans lequel la chambre à jet d'encre comprend une chambre d'éjection ayant les ouverture de buse et une antichambre ayant le trou, la chambre d'éjection étant latéralement raccordée à l'antichambre.

10. Procédé selon la revendication 9, dans lequel les parois de chambre définissent une paroi périmétrique de la chambre à jet d'encre.

11. Procédé selon la revendication 1, dans lequel la couche de résine photosensible en film sec a une épaisseur dans la plage de 5 à 20 microns.

12. Procédé selon la revendication 1, dans lequel la résine photosensible en film sec comprend une résine époxy.

13. Procédé selon la revendication 1, dans lequel l'étape de dépôt (iii) est réalisée en utilisant au moins un procédé de dépôt sélectionné parmi le groupe constitué de : CVD au TEOS ; CVD au plasma haute densité (HDPCVD) ; et CVD assisté par plasma (PECVD).

14. Procédé selon la revendication 13, dans lequel l'étape de dépôt (iii) comprend les sous-étapes de :
(a) le dépôt, en utilisant une première méthode de dépôt, d'un premier matériau de chambre pour remplir les ouvertures de paroi, ainsi formant les parois de chambre et formant au moins partiellement le toit de chambre ; et
(b) la planarisation d'une surface supérieure du premier matériau de chambre.

15. Procédé selon la revendication 14, comprenant les sous-étapes supplémentaires de :
(c) le dépôt, en utilisant une seconde méthode de dépôt, d'un second matériau de chambre par-dessus la surface supérieure planarisée du premier matériau de chambre afin de compléter la formation du toit de chambre.
